# EUROPÄISCHE PATENTSCHRIFT

(11) **EP 0 382 060 B1**
(45) Veröffentlichungstag und Bekanntmachung des Hinweises auf die Patenterteilung: **14.12.1994**
(21) Anmeldenummer: 90101801.0
(22) Anmeldetag: 30.01.1990
(51) Int. Cl.: E06B 3/66, E04B 1/74, H01L 31/048, H01L 31/0224, E04D 3/06, E04C 2/54

(54) **Fenster-, Wand-, Dach- oder Brüstungselement**
Window, wall, roof or parapet element
Elément de fenêtre, de paroi, de toit ou de garde-corps

(30) Priorität: 07.02.1989 DE 3903521
(43) Veröffentlichungstag der Anmeldung: 16.08.1990
(73) Patentinhaber: Kunert, Heinz, Dr., 50935 Köln (DE)
(72) Erfinder: Kunert, Johannes, D-53115 Bonn (DE); Kunert, Heinz, Dr., D-50935 Köln (DE)
(74) Vertreter: Degwert, Hartmut, Dipl.-Phys.

(56) Entgegenhaltungen:
- EP-A- 0 036 657
- EP-A- 0 204 562
- EP-A- 0 218 997
- EP-A- 0 243 912
- EP-A- 0 252 489
- WO-A-85/02649
- DE-A- 2 033 335
- DE-A- 2 037 288
- DE-A- 2 631 491
- DE-U- 8 511 416

## Beschreibung

Die Erfindung betrifft ein Fenster-, Wand-, Dach- oder Brüstungselement, mit wenigstens zwei transparenten Scheiben, einer wärmedämmenden Schicht zwischen den Scheiben und einer zwischen den Scheiben angeordneten flächigen photovoltaischen Einheit.

Fenster-, Wand-, Dach- oder Brüstungselemente können zur Raumheizung in Gebäuden beitragen, wenn sie geeignet konzipiert sind. Eine Umsetzung der Sonnenenergie in eine höherwertige Energieform, nämlich elektrische Energie, ist mit herkömmlichen Fenster-, Wand- oder Brüstungselementen bisher nicht möglich. Grundsätzlich läßt sich aber bekanntlich solare Energie über den photovoltaischen Effekt in elektrischen Strom umsetzen.

Photovoltaische Elemente haben aber einen eng begrenzten Wirkungsgrad. Zwar wird auftreffende Solarstrahlung fast vollständig absorbiert, die absorbierte solare Energie kann jedoch nur zu einem geringen Prozentsatz von etwa 5 bis 15 % in elektrische Energie umgesetzt werden. Der weit überwiegende Anteil der solaren Strahlungsenergie wird in Wärmeenergie verwandelt und durch Konvektion, Strahlung und Wärmeleitung ungenutzt an die Umgebung abgeführt.

Durch die limitierte Umwandlungseffizienz ist die zu erzielende elektro-energetische Gewinnrate photovoltaischer Elemente pro Flächeneinheit gering, so daß in Anbetracht der hohen Gestehenskosten solcher Elemente ihre Nutzung zur Gewinnung von elektrischer Energie zu annähernd wettbewerbsfähigen Preisen im Rahmen bereits bestehender Systeme der elektrischen Energieversorgung auch in fernerer Zukunft unrentabel bleiben dürfte.

Hinzu tritt noch der Aspekt der ungünstigen generellen Energie-Umwandlungsbilanz bei der Produktion von photovoltaischen Elementen. Der Gestehensprozeß erfordert mehr an primärer, hochwertiger und nicht erneuerbarer Energie als die Elemente im Laufe ihrer Lebensdauer zu erzeugen vermögen. Dies trifft besonders dann zu, wenn man in den Gestehensaufwand nicht nur die funktionalen Halbleiterschichtungen, sondern auch die Träger- und Abdeckplatten sowie die Rahmungen und Gestellvorrichtungen einbezieht.

Die EP-A-0 218 997 beschreibt ein Fensterelement der eingangs genannten Art. Dieses Fensterelement ist nach Art einer Isolierglasscheibe aufgebaut, wobei die photovoltaische Einheit an der Innenseite einer der Scheiben fixiert ist. Zusätzlich wird vorgeschlagen, die photovoltaische Einheit in einem Verbundglassystem zwischen zwei Trägern aus Glas anzuordnen.

Die Anwendung von photovoltaischen Elementen für die Entlastung der Energiebilanz eines Gebäudes kann aber unter energetischem und wirtschaftlichem Aspekt erst dann sinnvoll erscheinen, wenn es gelingt, die Elemente in den Baukörper so zu integrieren, daß mit ihrer Hilfe ein breites Spektrum an zusätzlichem Nutzen geschaffen werden kann.

Die nach einem ersten Aspekt der Erfindung im Patentanspruch 1 und nach einem zweiten Aspekt im Patentanspruch 8 angegebene Erfindung löst diese Aufgabe. Sie ermöglicht insbesondere, bereits nach dem heutigen Stand der Technik verfügbare photovoltaische Elemente als Bauelemente mit überzeugend positiver, ökologischer aber auch wirtschaftlicher Bilanz zu verwenden. Dies wird im wesentlichen durch zwei Maßnahmen erreicht:
1. Indem man photovoltaische Elemente so konfiguriert, daß sie wie herkömmliches Baumaterial eingesetzt werden oder an Stelle herkömmlicher Bauteile treten können. Auf diese Weise vermag man die genannten Kosten der Einhüllungsplatten, der Verrahmung sowie der Gestellkonstruktion zu neutralisieren, gleichfalls aber auch die der Stellflächen.
2. Indem man durch spezifische Anordnungen der Elemente im Rahmen der Bauteile den Energieanteil der auftreffenden solaren Energiestrahlung, der nicht in elektrische Energie transformiert wird, sondern in Wärmeenergie anfällt und der ansonsten nutzlos verloren geht, dem Gebäude in der Heizperiode zur Entlastung des Heizenergiebedarfs zuführt, dagegen aber in der Sommerperiode diese anfallende Wärmeenergie und zugleich die auf den Außenflächen des Gebäudes auftreffende Solarstrahlung zur Reduzierung des Kühlenergiebedarfs dem Gebäudeinneren fernhält.

Die erfinderische Idee löst letztlich die Aufgabe, das in Form von direkter oder diffuser Strahlung auf die Außenflächen eines Gebäudes auftreffende solare Energiespektrum zu ökonomischen Bedingungen für die Energieversorgung des Gebäudes zu nutzen.

Die Erfindung löst diese Aufgabe durch die in den Ansprüchen 1 und 8 genannten Merkmale.

In vorteilhafter Weise wird dabei dem dem jeweiligen Wirkungsgrad der verwendeten photovoltaischen Elemente entsprechenden Teil der solaren Strahlung für die Erzeugung hochwertiger elektrischer Energie der Vorrang eingeräumt. Der bei Applikation von photovoltaischen Elementen üblicherweise nicht auswertbare überwiegende Teil solarer Energiestrahlung, der in einer Größenordnung von etwa 90 % verbleibt, wird
- in der Heizperiode fast vollständig zur Gebäudeheizung verwendet,
- außerhalb der Heizperiode zur Entlastung anfallenden Kühlaufwandes vom Gebäudeinneren ferngehalten und
- bei Verwendung partiell transparenter photovoltaischer Elemente, wenn erwünscht, mit entsprechenden Anteilen dem Gebäudeinneren als Lichtstrahlung zugeführt.

Infolge dieser vielfältigen Nutzung kann die Kosten-Nutzen-Funktion von Photovoltaik-Elementen positiv gestaltet und ihnen zu einer breiten Marktpenetration verholfen werden. Durch die fast vollständige energetische Verwertung der auftref fenden solaren Strahlung und die Ausnutzung vorhandener Gebäudeelementstrukturen (Rahmen, Scheiben, Dichtung usw.) dürfte das bisherige Preis-Leistungsverhältnis, bezogen auf die bereits erreichte Energieumwandlungsrate (DM pro Watt) unter Einbeziehung der Flächenrelation (DM pro qm), Werte annehmen, die hinsichtlich der Energieversorgung von Gebäuden eine wirtschaftliche Nutzung gegenüber anderen, ökologisch bedenklichen Energieträgern ermöglichen.

Zur Umsetzung der Erfindung können an sich bekannte Einrichtungen und Techniken kombiniert werden. Die bisher verwendeten photovoltaischen Elemente teilen sich in zwei Systeme auf. Es handelt sich dabei einerseits um mono- oder polykristalline, andererseits um amorphe Halbleiterschichtungen, die auf Trägerplatten aufgebracht und mit einer für das solare Strahlungsspektrum hochtransparenten Schutzfolie überzogen werden. Benutzt man nun als Trägerplatte und ebenso als Schutzfolie eine Glasscheibe, so können die Elemente in Form einer Verbundscheibe ausgebildet werden.

Als ein weiteres Unterscheidungsmerkmal für photovoltaische Elemente ist ihre partielle Transparenz für den sichtbaren Bereich bzw. für den nahen Infrarot-Bereich in Betracht zu ziehen. Amorphe Systeme weisen in diesem Bereich eine Transmissionsrate von 10 bis 15% auf. Für die solare Strahlungstransmission erweisen sich solche Elemente als isotrop. Grundsätzlich können auch mono- und polykristalline Systeme unter gewisser Leistungseinbuße partiell transparent ausgebildet werden. In derzeitigen Ausführungsformen sind sie jedoch opak.

Der gegebenen Aufgabenstellung nach sollen solche Elemente als umhüllende Flächen in Baukörpern Anwendung finden, insbesondere als Fenster-, Brüstungs- oder Wandelemente. Zu diesem Zweck wird zunächst vorgeschlagen, für die Träger- und Abdeckplatten der Halbleiterbeschichtungen Glasscheiben zu verwenden. Man erhält auf diese Weise die Elemente als stabile Verbundglasscheiben. Entsprechend den Erfordernissen der Wärmedämmung im Bauwesen wird weiterhin vorgeschlagen, die so ausgeführten Verbundglasscheiben je mit einer weiteren Glasscheibe zu doppelscheibigen leistungsfähigen Isolierglassystemen grundsätzlich bekannter Art auszubilden, insbesondere mit einer bevorzugt auf der inneren Oberfläche der Verbundglasscheibe aufgetragenen Low-E-Beschichtung und einer die Wärmeleitung mindernden Gasfüllung des Scheibenzwischenraumes.

Bei außenseitiger Positionierung der Photovoltaik-Verbundglasscheibe erhält man ein Isolierglaselement mit hoch-effizienter Sonnenschutzfunktion. Die innenseitige emissionsmindernde Beschichtung der als Absorptionsscheibe wirkenden Verbundglasscheibe verhindert die raumseitige Wärmeabstrahlung.

Photovoltaik-Isolierglaselemente in der beschriebenen Ausführungsform stellen bereits eine Lösung der vorgegebenen Aufgabenstellung hinsichtlich der ökonomischen Integration photovoltaischer Elemente in den Baukörper dar. Im Verfolg der weitergehenden Aufgabenstellung, die von diesen Elementen absorbierte überschüssige, nicht in elektrische Energie transferierte anfallende Wärmeenergie im Bedarfsfall, also in der Heizperiode, möglichst vollständig zur Entlastung der Heizlast dem Rauminneren zuzuführen, wird erfindungsgemäß ferner vorgeschlagen, solche in den Baukörper integrierte Isolierglaselemente in Wende- oder Dreh-Rahmenkonstruktionen prinzipiell bekannter Art einzufassen. Solche Rahmenkonstruktionen ermöglichen eine Umpositionierung nach außen gerichteter Scheiben von Isolierglaselementen nach innen und umgekehrt.

In der Sommerperiode verbleibt das nach Art einer Verbundglasscheibe aufgebaute photovoltaische Element in Außenposition. Die in Wärmeenergie transferierte überschüssige solare Strahlungsenergie wird in dieser Position weitgehend nach außen konvektiv abgeführt oder abgestrahlt. Der Wärmedurchgang ins Rauminnere wird durch die rückseitige emissionsmindernde Beschichtung der Verbundscheibe und durch das zwischen den Scheiben des Isolierglassystems befindliche Luftvolumen weitgehend unterdrückt.

In der Heizperiode wird dagegen das photovoltaische Verbundglaselement zum Rauminneren positioniert. Das dann zur Außenfront liegende Luftvolumen sowie die entsprechend gelagerte Low-E-Beschichtung sind dann geeignet, Wärmeverluste des Verbundglaselements nach außen zu eliminieren. Die überschüssige Wärmeenergie der nunmehr auf die Rückseite des Elements auftreffenden Solarstrahlung kommt dann weit überproportional der Raumheizung zugute. Die durch die Außenscheibe entstehenden solaren Einstrahlungsverluste lassen sich bei Verwendung hoch-transparenter Glasscheiben mit vermindertem Eisenoxidgehalt auf eine Quote von etwa 8% begrenzen.

Dem erfindungsgemäßen Lösungskonzept der eingangs beschriebenen Aufgabenstellung liegt also die Idee zugrunde, photovoltaische Elemente als hochdämmende Wandbauteile auszubilden, wobei hinsichtlich des solaren Strahlungsspektrums transparente Wärmedämmungsmedien wie Luftvolumina und wärmereflektierende Schichten Anwendung finden, die in der Sommerperiode raumseitig und in der Heizperiode außenseitig anzuordnen sind.

In bevorzugter Weise kann diese Idee durch folgende Maßnahmen realisiert werden:
1. durch Einbettung photovoltaischer Schichtungen in eine Verbundglasscheibe mit symmetrischem Aufbau und bezüglich der Strahlungstransmission isotroper Struktur;
2. durch Einbindung solcher Verbundglasscheiben als Außenscheibe eines hocheffizienten zwei- oder mehrscheibigen Isolierglaselementes;
3. durch Integration dieses Isolierglaselementes in eine Rahmenkonstruktion, die eine Rotation oder Wendung des Elements um 180° ermöglicht.

Im Falle der Verwendung von photovoltaischen Elementen mit asymmetrischem Aufbau und einer opaken Trägerschicht, die also nur einen einseitigen Strahlungszugang ermöglichen, bedarf es, um eine wechselseitige Anordnung von transparenten wärmeisolierenden Medien zu erreichen, anderer Ausführungsformen zur funktionsgerechteren Produktgestaltung.

Für diesen Fall wird vorgeschlagen, solche photovoltaischen Elemente in Folienstruktur oder als formstabile Platten in den Zwischenraum eines doppelscheibigen Isolierglaselements mit der "strahlungsoffenen" Fläche der solaren Strahlungsquelle zugewandt einzubringen. Sie werden im Scheibenzwischenraum parallel verschiebbar zu den Scheibenflächen aufhängt, so daß sie steuerbar sowohl an die Außenscheibe als auch an die Innenscheibe des Isolierglaselements angelegt oder angedrückt werden können. Dies kann durch mechanische, magnetische oder pneumatische Führungs- und Steuerungssysteme erreicht werden.

In einfachster Weise läßt sich die An- und Abkopplung des photovoltaischen Plattenelements an die jeweilige Glasscheibe durch ein quasipneumatisches System bewerkstelligen, indem man zwischen diesem Plattenelement und den Glasscheiben luftdichte Kammern ausbildet und sie im Gegentakt evakuiert oder mit Druckluft beaufschlagt.

Zusätzlich wird vorgeschlagen, entweder auf die inneren Oberflächen beider Glasscheiben oder aber beidseitig auf die Oberflächen der photovoltaischen Platte Low-E-Beschichtungen auf zutragen. In Sommerposition liegt die photovoltaische Platte der Außenscheibe des Isolierglaselements an. Die absorbierte überschüssige Wärmeenergie wird dann durch Wärmeleitung unmittelbar auf die Außenscheibe übertragen und hier wie im Falle der zuvor beschriebenen Ausführungsform durch Konvektion oder Strahlung an die Außenluft abgeführt. Die Wärmeabstrahlung zum Raum hin wird durch die innenseitig angeordnete Low-E-Beschichtung unterdrückt; der auf Wärmeleitung beruhende Wärmetransport wird durch die wärmedämmende Schicht unterdrückt.

In der Heizperiode liegt dagegen die photovoltaische Platte der dem Innenraum zugewandten Scheibe des Isolierglaselements an. Die überschüssige Wärmeenergie der Platte wird dann durch Wärmeleitung auf diese Innenscheibe übertragen und von hier dem Rauminneren konvektiv oder über Wärmestrahlung zugeführt. Durch die nunmehr rückwärtig zur photovoltaischen Platte positionierten Low-E-Schichten entstehen nur geringe Wärmestrahlungsverluste zur Außenatmosphäre.

Die Ableitung der von den photovoltaischen Elementen absorbierten überschüssigen Wärmemengen in jeweils eine Richtung erfolgt, wie beschrieben, durch entsprechende Positionierung der wärmedämmenden Schichtungen entweder auf der der solaren Energiequelle zugewandten oder der von ihr abgewandten Seite dieser Elemente. Die jeweils einseitige Abführung der Wärmemengen kann durch Erhöhung der Wärmewiderstands dieser Schichtungen noch verstärkt werden. Beispielsweise kann an die Stelle des Luftvolumens ein die Wärmeleitung minderndes oder die Wärmestrahlung absorbierendes Edelgas treten. Als überaus vorteilhaft würde sich die Evakuiervng des Scheibeninnenraums auswirken.

Bei der zuerst beschriebenen Ausführungsform sind zur Erhöhung der Wärmewiderstände für die solare Strahlung hochtransparente, konvektionsmindernde Strukturmaterialien vorteilhaft. Insbesondere eignen sich hierzu Kapillarstrukturen und sogenannte Silica-Airogel-Stukturstoffe.

In einer dritten Ausführungsform wird eine nur partielle Ausrüstung der Isolierglaselemente mit photovoltaischen Schichtungen in verschiedenartiger Konfiguration vorgeschlagen. Solche Elemente dürften sich insbesondere für Fenster-und geschoßhohe Umhüllungsstrukturen eignen.

Weitere Merkmale und Vorteile der Erfindung ergeben sich aus der folgenden Beschreibung mehrerer Ausführungsformen und aus der Zeichnung, auf die Bezug genommen wird. In der Zeichnung zeigen:
- Fig. 1 bis 4: mehrere Ausführungsformen der erfindungsgemäßen Einheit im Querschnitt;
- Fig. 5: eine Draufsicht einer weiteren Ausführungsform des erfindungsgemäßen Elements;
- Fig. 6: eine schematische Perspektivansicht eines Rotationsfensters, in dem die erfindungsgemäße Einheit zur Anwendung kommt;
- Fig. 7: schematische Ansichten der verschiedenen Stellungen des in Fig. 6 gezeigten Rotationsfensters zur Erläuterung seiner Funktion; und
- Fig. 8: einen Teilschnitt einer weiteren Ausführungsform.

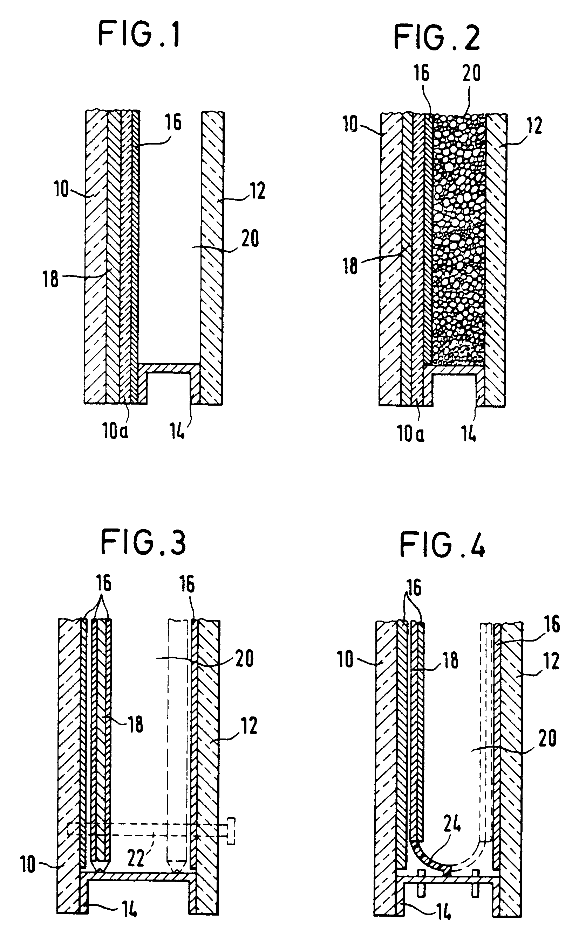

Bei der in Fig. 1 gezeigten Ausführungsform besteht das Fenster-, Wand-, Dach- oder Brüstungselement aus zwei nach Art einer Isolierglasscheibe im Abstand voneinander angeordneten tranparenten Scheiben oder Platten 10, 12, insbesondere Glasscheiben. Die beiden Glasscheiben 10, 12 werden in herkömmlicher Weise durch einen im Querschnitt U-förmigen Abstandshalterrahmen 14 zusammengehalten. Auf der Innenseite der Glasscheibe 10 ist eine flächige oder plattenförmige photovoltaische Einheit 18 befestigt. Auf der Einheit 18 ist eine transparente Scheibe oder Platte 10a angeordnet. Diese Scheibe oder Platte 10a ist auf ihrer der Glasscheibe 12 zugewandten Fläche mit einer Low-E-Beschichtung 16 versehen. Auch die Scheibe 12 weist vorzugsweise auf ihrer der Einheit 18 zugewandten Fläche eine Low-E-Beschichtung 16 auf. Eine solche Beschichtung weist vorzugsweise einen Emissionskoeffizienten in der Größenordnung von 0,06 auf. Der verbleibende Raum zwischen den Scheiben 10, 12 bildet eine wärmedämmende Schicht 20 und ist mit Luft oder vorzugsweise einem Edelgas gefüllt. Die wärmedämmende Schicht 20 kann auch durch Evakuierung des Raumes zwischen den Scheiben 10, 12 gebildet werden. Die Scheibe 10, die Einheit 18 und die Scheibe oder Platte 10a sind nach Art einer Verbundglasscheibe miteinander kombiniert.

Je nach Verwendungszweck des Elements wird die photovoltaische Einheit 18 aus unterschiedlichem Material hergestellt. Wenn das Element lichtdurchlässig sein soll, wird vorzugsweise ein amorphes Halbleitermaterial verwendet. Wenn das Element opak sein darf oder eine nur geringe Lichtdurchlässigkeit zugelassen oder verlangt wird, besteht die photovoltaische Einheit aus poly- oder monokristallinem Halbleitermaterial. Insbesondere wird isotropes Material verwendet, so daß der Strahlungseinfall auf der Vorderseite zu gleicher Umwandlungsleistung wie auf der Rückseite führt.

Einzelheiten der photovoltaischen Einheit werden hier nicht näher beschrieben, da diese prinzipiell in herkömmlicher Weise ausgebildet sein kann.

Bei der in Fig. 2 gezeigten Ausführungsform ist der Raum zwischen den Scheiben 10, 12 mit einem transparenten Struktur-Wärmedämmstoff ausgefüllt. Derartige Stoffe sind prinzipiell bekannt, z.B. Waben-, Kammer- und Kapillarstrukturstoffe aus Polycarbonat, Polystyrol, Polyamid und Polyvinylchlorid. Besonders geeignet ist ein unter der Bezeichnung Aerogel bekanntes Material. Ansonsten stimmt die in Fig. 2 gezeigte Ausführungsform mit der nach Fig. 1 überein.

Bei der Ausführungsform nach den Figuren 3 und 4 ist die photovoltaische Einheit 18 beweglich zwischen den zwei Scheiben 10, 12 angeordnet, die innenseitig mit einer emissionsmindernden Low-E-Beschichtung 16 versehen sind. Durch eine geeignete Steuereinrichtung wird das bei dieser Ausführungsform vorzugsweise beidseitig mit einer Low-E-Beschichtung versehene photovoltaische Einheit 18 selektiv mit der Innenseite der einen oder anderen Scheibe 10, 12 in Berührung gebracht und daran angelegt. Bei der Ausführungsform nach Fig. 3 sind zu diesem Zweck Führungsstangen 22 vorgesehen, welche sich quer zu der photovoltaischen Einheit 18 erstrecken. Bei der Ausführungsform nach Fig. 4 ist die photovoltaische Einheit 18 mit einer flexiblen Randeinspannung 24 versehen, über deren Außenrand sie am Abstandshalterrahmen 14 befestigt ist. Bei dieser Ausführungsform kann die photovoltaische Einheit insgesamt eine flexible Folie bilden. Sie trennt zwischen den Scheiben 10, 12 zwei Kammern ab, durch deren selektive Beaufschlagung mit einem Medium bzw. Evakuierung die photovoltaische Einheit zwischen den zwei Scheiben 10, 12 bewegt und jeweils an die Innenfläche der betreffenden Scheibe angelegt werden kann.

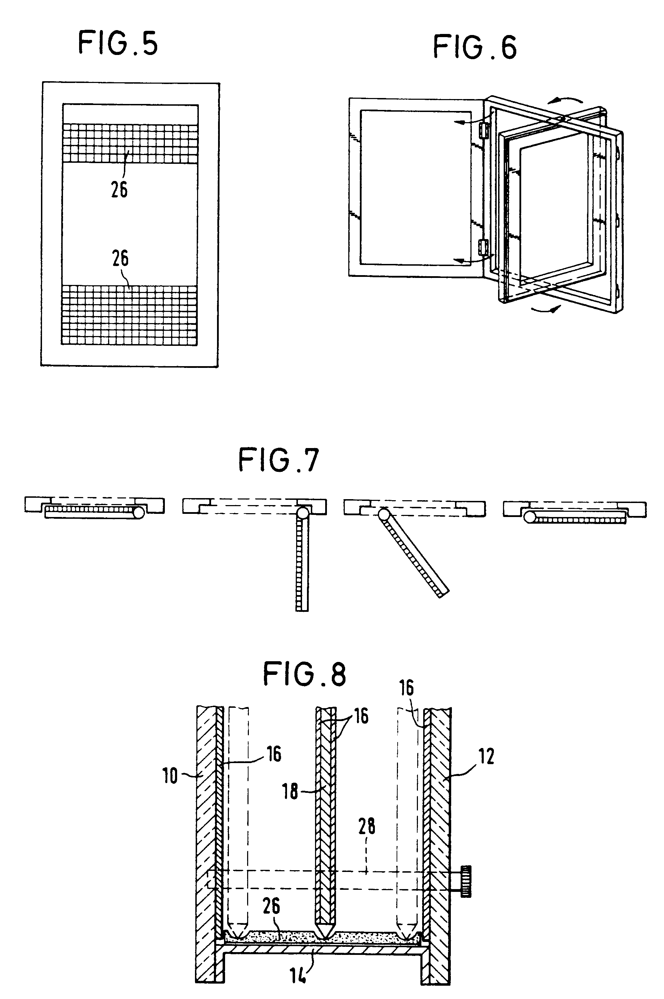

Bei der in Fig. 5 gezeigten Ausführungsform ist das Element nicht ganzflächig, sondern in Form von horizontalen Streifen 26 mit einer photovoltaischen Einheit versehen.

Fig. 6 zeigt eine vorteilhafte Verwendung des erfindungsgemäßen Elements nach irgendeiner der beschriebenen Ausführungsformen in einem durch Rotation eines Fensterflügels um eine mittlere Hochachse um 180° wendbaren Fenster.

Fig. 7 zeigt schematisch das Wenden eines Fensterflügels um 180° durch translatorisches Verschieben einer der Seitenachsen.

Gegenstand der Erfindung ist ferner das in Fig. 8 schematisch gezeigte Fenster-, Wand-, Dach- oder Brüstungselement. Dieses Element ist prinzipiell in gleicher Weise wie das nach der in Fig. 3 gezeigten Ausführungsform ausgebildet, weist aber die zusätzliche Besonderheit auf, daß die Einheit 18 außer ihren gestrichelt gezeigten Endstellungen in Anlage an der Innenseite der Scheibe 10 oder 12 Zwischenstellungen einnehmen kann, insbesondere eine mittige Stellung, in der sie den zwischen den Scheiben 10, 12 gebildeten Raum in zwei getrennte, etwa gleich große Kammern unterteilt. Die translatorische Einstellung der Einheit 18 kann beispielsweise mittels eines Spindelantriebs erfolgen, der in Fig. 3 sehr schematisch angedeutet und mit dem Bezugszeichen 28 bezeichnet ist. Am Außenumfang steht die Einheit 18 über ihre Kanten mit einem Dichtstreifen 26 aus nachgiebigem Material in Dichteingriff. Die beiderseits von der Einheit 18 gelegenen Kammern sind also gegeneinander abgedichtet. Die Einheit 18 ist eine photovoltaische Einheit und beidseitig mit einer emissionshemmenden Beschichtung 16 versehen.

Der Abstand der Scheiben 10, 12 voneinander beträgt etwa 30 mm.

Das Element nach der in Fig. 8 gezeigten Ausführungsform zeichnet sich durch einen regelbaren k-Wert aus, worunter der Wärmedurchgang durch das Element in Watt/m² und K verstanden wird. Ein zweischeibiges Isolierglaselement erreicht k-Werte bis herab zu 1,3 Watt/m²K. Prinzipiell läßt sich bei einer Isolierverglasung der k-Wert durch Vergrößerung des Abstandes zwischen den Scheiben steigern. Eine Verbreiterung des Scheibenabstandes über etwa 15 mm hinaus führt aber zu keiner weiteren Verringerung des k-Wertes, da der mit der Dicke der Luft- oder Edelgasschicht zunehmende Wärmewiderstand durch die Zunahme der Wärmeübertragung durch Konvektion wieder aufgehoben wird.

Bei der hier beschriebenen Ausführungsform wird hingegen durch die Ausdehnung des Abstandes zwischen den Scheiben 10, 12 auf etwa 30 mm eine erhebliche Verminderung des k-Wertes bis in die Größenordnung von etwa 0,8 Watt/m²K erzielt, weil die Einheit 18, wenn sie mittig zwischen den Scheiben 10, 12 angeordnet ist, zwei gleich große Kammern von jeweils etwa 15 mm Dicke abgrenzt. In dieser Stellung der Einheit 18 verhält sich das Element ähnlich wie ein dreischeibiges Isolierglaselement mit jeweils 15 mm Scheibenabstand.

Die Positionierung der Einheit 18 wird durch einen Steuermechanismus in Abhängigkeit von Parametern wie Innentemperatur, Außentemperatur, Strahlungseinfall von außen und Witterungsbedingungen gesteuert. Zu Nachtzeiten oder Zeiten mit geringem Strahlungseinfall wird die Einheit 18 in die in Fig. 8 gezeigte mittlere Stellung gebracht. Während der Heizperiode wird die Einheit 18, sofern eine nutzbare solare Einstrahlung stattfindet, in Anlage an die Innenseite der dem Gebäudeinneren zugewandten Scheibe gefahren. Wenn in der Sommerperiode das Eindringen der solaren Strahlung in das Gebäudeinnere gehemmt werden soll, wird die Einheit 18 in Anlage an die Innenseite der vom Gebäudeinneren abgewandten Scheibe gefahren.

Ein weiterer interessanter Aspekt der Erfindung besteht darin, daß die emissionsmindernde Beschichtung 16, die bei allen beschriebenen Ausführungsformen auf der Innenseite der dem Gebäudeinneren zugewandten Scheibe vorhanden ist, als elektrischer Heizwiderstand verwendet wird. Gängige Low-E-Beschichtungen weisen einen ohmschen Flächenwiderstand auf, der in der Größenordnung von einigen Ohm/m² liegt, so daß für Heizzwecke Versorgungsspannungen angelegt werden können, die in der Größenordnung der Netzwechselspannung liegen und auch durch Reihenschaltung einer Vielzahl von photovoltaischen Elementen erzeugt werden können. In Weiterbildung der Erfindung ist daher vorgesehen, die von der photovoltaischen Einheit 18 erzeugte elektrische Energie zur Speisung eines elektrischen Heizwiderstandes zu nutzen, der durch die emissionsmindernde Beschichtung auf der Innenseite der dem Rauminneren zugewandten Scheibe gebildet ist. Die Besonderheit dieser Form der Nutzung der durch die photovoltaische Einheit 18 erzeugten elektrischen Energie liegt darin, daß die dem Rauminneren zugewandte Scheibe durch die zusätzliche Beheizung auf eine Temperatur gebracht werden kann, die etwa gleich der Raumtemperatur ist. Es ergeben sich dann folgende Vorteile: Zunächst wird kein zusätzliches Heizelement benötigt. Es steht bereits mit der emissionsmindernden Beschichtung der dem Rauminneren zugewandten Glasscheibe zur Verfügung. Durch Aufheizen der dem Innenraum zugewandten Scheibe auf Raumtemperatur werden die thermischen Transmissionsverluste kompensiert. Man erreicht über die gesamte Tageszeit der Heizperiode eine thermisch neutrale Wandfläche mit praktisch einem k-Wert von 0 Watt/m²k. Der Energieaufwand zur Heizung der Scheibe bis auf Raumtemperatur ist sehr gering, da nur der Verlustwärmestrom des Isolierglaselements kompensiert werden muß. Der Energieaufwand entspricht also dem k-Wert des Isolierglaselements. Bei einem k-Wert des Isolierglaselements von 1,3 Watt/m²k beträgt er also das 1,3-fache der Differenz zwischen Innen- und Außentemperatur. Dieser der Innenscheibe zuzuführende geringe Energiebetrag führt aber bereits zu dem Vorteil einer behaglichen Nutzung des nahen Fensterraumes, da Strahlungsverluste, wie überhaupt Wärmetransmissionsverluste, durch das Fenster hindurch vermieden werden. Mit relativ geringem Energieaufwand wird so der Wärmestrom nach außen unterdrückt.

Weiterhin ist vorgesehen, den so verfügbaren elektrischen Heizwiderstand zu Zeiten geringer Solareinstrahlung und zu Nachtzeiten während der Heizperiode bei Bedarf aus dem Wechselstromnetz des Gebäudes zu speisen.

Wenn die dem Gebäudeinneren zugewandte Scheibe bereits durch solare Einstrahlung auf Raumtemperatur und darüber aufgeheizt wird oder wenn die photovoltaische Einheit 18 tagsüber mehr elektrische Energie liefert als zur Beheizung der Scheibe bis auf Raumtemperatur benötigt wird, kann über eine geeignete temperaturgesteuerte Regelung die überschüssige Energie in einem Akkumulator gespeichert werden, um für Zeiten mit geringerer Solareinstrahlung, insbesondere Nachtzeiten, zur Verfügung zu stehen.

Weiterhin ist vorgesehen, den im Scheibenelement verfügbaren elektrischen Heizwiderstand zu Zeiten geringer Solareinstrahlung und zu Nachtzeiten in der Heizperiode aus dem Wechselstromnetz des Gebäudes zu speisen. Es ist dann vorteilhaft, die vorhandene Widerstandsheizung durch Aufbringung höherer Temperaturen für die Raumerwärmung überhaupt zu nutzen, also z.B. zur Kompensation von Lüftungsverlusten. Man spart dadurch an Kosten und an Raumbedarf für ein auch bei hoher solarer Nutzungsrate stets zusätzlich einzurichtendes Heizsystem, und man gewinnt zudem den thermischen Nutzen und den Komfort einer großflächigen, flexiblen Strahlungsheizung. In energetisch höchst rationeller Weise könnte dann die Netzeinspeisung nach Bedarf jeweils kompensatorisch zur einfallenden solaren Strahlungsenergie geschaltet werden.

## Patentansprüche

1. Fenster-, Wand-, Dach- oder Brüstungselement, mit wenigstens zwei transparenten Scheiben (10, 12), einer wärmedämmenden Schicht (20) zwischen den Scheiben und einer zwischen den Scheiben angeordneten flächigen photovoltaischen Einheit (18), dadurch gekennzeichnet, daß die Scheiben (10, 12) in einen um 180° wendbaren Rahmen eingesetzt sind, und daß die photovoltaische Einheit (18) auf der Innenseite einer der Scheiben (10) angeordnet und auf ihrer der wärmedämmenden Schicht (20) zugewandten Seite mit einer Low-E-Beschichtung (16) versehen ist.

2. Element nach Anspruch 1, dadurch gekennzeichnet, daß die Innenseite der Scheibe (12), welche der photovoltaischen Einheit (18) gegenüberliegt, mit einer Low-E-Beschichtung (16) versehen ist.

3. Element nach einem der Ansprüche 1 oder 2, dadurch gekennzeichnet, daß die photovoltaische Einheit (18) mittels einer beidseitig haftenden transparenten Klebefolie auf einer der Scheiben (10) befestigt ist.

4. Element nach einem der Ansprüche 1 bis 3, dadurch gekennzeichnet, daß die photovoltaische Einheit (18) nach Art einer Verbundscheibe zwischen zwei Scheiben (10, 10a) angeordnet und mit diesen in Verbund ist.

5. Element nach einem der Ansprüche 1 bis 4, dadurch gekennzeichnet, daß die wärmedämmende Schicht (20) durch eine Füllung aus einem transparenten Material von geringer Wärmeleitfähigkeit gebildet ist.

6. Element nach Anspruch 5, dadurch gekennzeichnet, daß dieses Material eine kapillare Struktur aufweist.

7. Element nach Anspruch 6, dadurch gekennzeichnet, daß dieses Material aus einem Silica-Airogel-Strukturstoff besteht.

8. Fenster-, Wand-, Dach- oder Brüstungselement, mit wenigstens zwei transparenten Scheiben (10, 12), einer wärmedämmenden Schicht (20) zwischen den Scheiben und einer zwischen den Scheiben angeordneten flächigen photovoltaische Einheit (18), dadurch gekennzeichnet, daß die photovoltaische Einheit (18) zwischen zwei Stellungen, in denen sich diese Einheit jeweils flächig in Anlage an der Innenfläche einer der beiden Scheiben (10, 12) befindet, beweglich angeordnet und auf ihren beiden Flächen jeweils mit einer Low-E-Beschichtung (16) versehen ist.

9. Element nach Anspruch 8, dadurch gekennzeichnet, daß die photovoltaische Einheit (18) auf ihren beiden Flächen und die beiden Scheiben (10, 12) jeweils auf ihrer Innenfläche mit einer Low-E-Beschichtung (16) versehen sind.

10. Element nach einem der Ansprüche 8 oder 9, dadurch gekennzeichnet, daß die photovoltaische Einheit (18) in wenigstens einer Zwischenstellung etwa mittig zwischen den zwei Scheiben (10, 12) einstellbar ist.

11. Element nach einem der Ansprüche 8 bis 10, dadurch gekennzeichnet, daß die photovoltaische Einheit (18) mittels einer flexiblen Randaufhängung (24) zwischen den beiden Scheiben (10, 12) aufgehängt ist.

12. Element nach einem der Ansprüche 8 bis 11, dadurch gekennzeichnet, daß die photovoltaische Einheit (18) durch selektive Beaufschlagung der durch sie zwischen ihr und den zwei Scheiben (10, 12) abgegrenzten Kammern mit einem Gas bzw. mit Vakuum zwischen den Scheiben bewegbar und an die Innenfläche der jeweiligen Scheibe anlegbar ist.

13. Element nach einem der Ansprüche 8 bis 12, dadurch gekennzeichnet, daß ein Steuerungssystem vorgesehen ist, welches die Einstellung der photovoltaischen Einheit (18) zwischen den zwei Scheiben (10, 12) in Abhängigkeit von Parametern wie Innen-, Außentemperatur, Strahlungseinfall von außen und Witterungsbedingungen steuert.

14. Element nach einem der Ansprüche 8 bis 13, dadurch gekennzeichnet, daß die Kanten der photovoltaische Einheit (18) mit einem Dichtstreifen (26) aus nachgiebigem Material in Dichtkontakt stehen.

15. Element nach einem der Ansprüche 8 bis 14, dadurch gekennzeichnet, daß die der Rauminnenseite zugewandte Scheibe (10) mit einer metallischen Low-E-Beschichtung (16) versehen ist, die zugleich einen flächigen Heizwiderstand bildet.

16. Element nach Anspruch 15, dadurch gekennzeichnet, daß die durch die photovoltaische Einheit erzeugte elektrische Energie wenigstens teilweise dem flächigen Heizwiderstand zugeführt wird.

17. Element nach Anspruch 16, dadurch gekennzeichnet, daß der Anteil der durch die photovoltaische Einheit erzeugten elektrischen Energie, welcher dem Heizwiderstand zugeführt wird, so gesteuert wird, daß die Temperatur der der Rauminnenseite zugewandten Scheibe (10) zumindest annähernd gleich der Raumtemperatur ist.

18. Element nach einem der Ansprüche 15 bis 17, dadurch gekennzeichnet, daß zumindest ein Teil der durch die photovoltaische Einheit erzeugten elektrischen Energie in einem Akkumulator zwischengespeichert wird.

19. Element nach einem der Ansprüche 15 bis 18, dadurch gekennzeichnet, daß der flächige Heizwiderstand selektiv an die Gebäudestromversorgung anschließbar ist.

20. Element nach einem der Ansprüche 8 bis 19, dadurch gekennzeichnet, daß der Abstand zwischen den zwei Scheiben (10, 12) etwa 30 mm beträgt.

21. Element nach einem der vorstehenden Ansprüche, dadurch gekennzeichnet, daß die wärmedämmende Schicht (20) durch eine Gasschicht gebildet ist.

22. Element nach einem der Ansprüche 1 bis 21, dadurch gekennzeichnet, daß die wärmedämmende Schicht durch einen zwischen den zwei Scheiben befindlichen, mindestens teilevakuierten Raum gebildet ist.

23. Element nach einem der vorstehenden Ansprüche, dadurch gekennzeichnet, daß die photovoltaische Einheit (18) aus poly- oder monokristallinem Halbleitermaterial aufgebaut ist.

24. Element nach einem der Ansprüche 1 bis 22, dadurch gekennzeichnet, daß die photovoltaische Einheit (18) aus amorphem Halbleitermaterial aufgebaut ist.

25. Element nach einem der vorstehenden Ansprüche, dadurch gekennzeichnet, daß die photovoltaische Einheit (18) nur einen Teil der Flächenausdehnung des Elements einnimmt.

26. Element nach Anspruch 25, dadurch gekennzeichnet, daß die photovoltaische Einheit (18) als horizontaler Streifen ausgebildet ist.

## Claims

1. A window element, wall element, roof element or balustrade element having at least two transparent panes (10, 12), a thermally insulating layer (20) between said panes and a sheet-like photovoltaic unit (18) arranged between said panes, characterized in that the panes (10, 12) are inserted into a frame, said frame being turnable through 180°, and in that the photovoltaic unit (18) is arranged on the inner side of one of the panes (10) and is provided on its side facing the thermally insulating layer (20) with a low-E covering (16).

2. The element according to claim 1, characterized in that the inner side of said pane (12) which is opposite to the photovoltaic unit (18) is provided with a low-E covering (16).

3. The element according to claim 1 or claim 2, characterized in that the photovoltaic unit (18) is secured to one of the panes (10) by means of a transparent adhesive film adhesive on both sides.

4. The element according to any one of claims 1 to 3, characterized in that the photovoltaic unit (18) is arranged in the manner of a composite or laminate pane between two panes (10, 10a) and is bonded to the latter.

5. The element according to any one of claims 1 to 4, characterized in that the thermally insulating layer (20) is formed by a filling of a transparent material having a low thermal conductivity.

6. The element according to claim 5, characterized in that the material has a capillary structure.

7. The element according to claim 6, characterized in that the material consists of a silica airogel structured material.

8. A window element, wall element, roof element or balustrade element having at least two transparent panes (10, 12), a thermally insulating layer (20) between the panes and a sheet-like photovoltaic unit (18) arranged between the panes, characterized in that the photovoltaic unit (18) is movably arranged between two positions, wherein the photovoltaic unit (18) in each of the positions is in area contact with the inner face of one of the two panes (10, 12), and in that the photovoltaic unit (18) is provided on both of its faces with a low-E covering (16).

9. The element according to claim 8, characterized in that the photovoltaic unit (18) is provided with a low-E covering (16) on both of its sides and the two panes (10, 12) are each provided on their inner faces with a low-E covering (16).

10. The element according to either one of claims 8 or 9, characterized in that the photovoltaic unit (18) is adjustable into at least one intermediate position substantially centrally between the two panes (10, 12).

11. The element according to any one of claims 8 to 10, characterized in that the photovoltaic unit (18) is suspended by means of a flexible edge suspension (24) between the two panes (10, 12).

12. The element according to any one of claims 8 to 11, characterized in that the photovoltaic unit (18) is movable between the panes and is applicable to the inner face of the respective pane by selectively subjecting the chambers defined by said photovoltaic unit (18) and the two panes (10, 12) to a gas pressure or a vacuum.

13. The element according to any one of claims 8 to 12, characterized in that a control system is provided which controls the setting of the photovoltaic unit (18) between the two panes (10, 12) in dependence upon parameters such as internal temperature, external temperature, radiation incidence from the outside and weather conditions.

14. The element according to any one of claims 8 to 13, characterized in that edges of the photovoltaic unit (18) are in sealing contact with a sealing strip (26) of yieldable material.

15. The element according to any one of claims 8 to 14, characterized in that the pane (10) facing the room interior is provided with a metallic low-E covering (16) which forms at the same time a sheet-like heating resistance.

16. The element according to claim 15, characterized in that electrical energy generated by the photovoltaic unit (18) is at least partially supplied to the sheet-like heating resistance.

17. The element according to claim 16, characterized in that the fraction of the electrical energy generated by the photovoltaic unit (18) which is supplied to the heating resistance is controlled in such a manner that the temperature of the pane (10) facing the room interior is at least approximately equal to the temperature in that room.

18. The element according to any one of claims 15 to 17, characterized in that at least part of the electrical energy generated by the photovoltaic unit (18) is intermediately stored in an accumulator.

19. The element according to any one of claims 15 to 18, characterized in that the sheet-like heating resistance is connectable selectively to the electrical power supply of a building.

20. The element according to any one of claims 8 to 19, characterized in that the distance between the two panes (10, 12) is about 30 mm.

21. The element according to any one of the foregoing claims, characterized in that the thermally insulating layer (20) is formed by a gas layer.

22. The element according to any one of claims 1 to 21, characterized in that the thermally insulating layer (20) is formed by an at least partially evacuated space located between the two panes.

23. The element according to any one of the foregoing claims, characterized in that the photovoltaic unit (18) is made up of polycrystalline or monocrystalline semiconductor material.

24. The element according to any one of claims 1 to 22, characterized in that the photovoltaic unit (18) is made up of amorphous semiconductor material.

25. The element according to any one of the foregoing claims, characterized in that the photovoltaic unit (18) takes up only a part of the element area.

26. The element according to claim 25, characterized in that the photovoltaic unit (18) is formed as an horizontally extending strip.

## Revendications

1. Elément de fenêtre, paroi, toit ou de balustrade, comportant au moins deux vitres transparentes (10, 12), une couche (20) thermiquement isolante entre les vitres et une unité plane photovoltaique (18) disposée entre les vitres, caractérisé en ce que les vitres (10, 12) sont montées dans un cadre apte à être tourné de 180°, et en ce que l'unité photovoltaique (18) est disposée du côté intérieur d'une (10) des vitres et est pourvue d'une couche Low-E (16) de son côté faisant face à la couche thermiquement isolante (20).

2. Elément suivant la revendication 1, caractérisé en ce que la face intérieure de la vitre (12) opposée à l'unité photovoltaique (18) est pourvue d'une couche Low-E (16).

3. Elément suivant l'une des revendications 1 et 2, caractérisé en ce que l'unité photovoltaique (18) est fixée sur une des vitres (10) au moyen d'une feuille adhésive transparente qui adhère sur ses deux côtés.

4. Elément suivant l'une des revendications 1 à 3, caractérisé en ce que l'unité photovoltaique (18) est agencée entre deux vitres (10, 10a) à la manière d'un verre feuilleté et est en liaison avec celles-ci.

5. Elément suivant l'une des revendications 1 à 4, caractérisé en ce que la couche (20) thermiquement isolante est constituée par un remplissage en une matière transparente de faible conductivité thermique.

6. Elément suivant la revendication 5, caractérisé en ce que cette matière présente une structure capillaire.

7. Elément suivant la revendication 6, caractérisé en ce que cette matière consiste en une substance de structure en airogel silica.

8. Elément de fenêtre, paroi, toit ou de balustrade, comportant au moins deux vitres transparentes (10, 12), une couche (20) thermiquement isolante entre les vitres et une unité plane photovoltaique (18) disposée entre les vitres, caractérisé en ce que l'unité photovoltaique (18) est agencée de manière mobile entre deux positions, dans chacune desquelles cette unité se trouve plane en appui sur la face interne d'une des deux vitres (10, 12) et est munie sur chacune de ses deux faces d'une couche Low-E (16).

9. Elément suivant la revendication 8, caractérisé en ce que l'unité photovoltaique (18) est munie sur ses deux faces d'une couche Low-E (16), tout comme les deux vitres (10, 12) sur chacune de leurs faces internes.

10. Elément suivant l'une des revendications 8 et 9, caractérisé en ce que l'unité photovoltaique (18) peut être ajustée au moins dans une position intermédiaire située à peu près au milieu entre les deux vitres (10, 12).

11. Elément selon l'une des revendications 8 à 10, caractérisé en ce que l'unité photovoltaique (18) est suspendue entre les deux vitres (10, 12) au moyen d'une suspension flexible de bord (24).

12. Elément suivant l'une des revendications 8 à 11, caractérisé en ce que l'unité photovoltaique (18) peut, par sollicitation sélective des chambres qu'elle délimite entre elle et les deux vitres (10, 12), être déplacée entre les vitres par un gaz ou par du vide, et peut être appliquée sur la face interne de la vitre respective.

13. Elément suivant l'une des revendications 8 à 12, caractérisé en ce qu'un système de commande est prévu, qui commande la position de l'unité photovoltaique (18) entre les deux vitres (10, 12) en fonction de paramètres tels que la température interne, la température externe, l'incidence de rayonnement de l'extérieur et conditions atmosphériques.

14. Elément suivant l'une des revendications 8 à 13, caractérisé en ce que les arêtes de l'unité photovoltaique (18) sont en contact étanche avec une bande d'étanchéité (26) réalisée en une matière souple.

15. Elément suivant l'une des revendications 8 à 14, caractérisé en ce que la vitre (10) faisant face à l'intérieur de la chambre est munie d'une couche métallique Low-E (16), qui constitue en même temps un conducteur chauffant plan.

16. Elément suivant la revendication 15, caratérisé en ce que l'énergie électrique produite par l'unité photovoltaique est au moins en partie menée au conducteur chauffant plan.

17. Elément suivant la revendication 16, caractérisé en ce que la proportion d'énergie électrique produite par l'unité photovoltaique, qui est amenée au conducteur chauffant, est commandée de sorte que la température de la vitre (10) faisant face à l'intérieur de la chambre soit au moins approximativement égale à la température règnant dans la chambre.

18. Elément suivant l'une des revendications 15 à 17, caractérisé en ce qu'au moins une partie de l'énergie electrique produite par l'unité photovoltaique est stockée temporairement dans un accumulateur.

19. Elément suivant l'une des revendications 15 à 18, caractérisé en ce que le conducteur chauffant plan peut êetre sélectivement raccordé à l'alimentation en électricité du bâtiment.

20. Elément suivant l'une des revendications 8 à 19, caractérisé en ce que la distance entre les deux vitres (10, 12) est d'environ 30 mm.

21. Elément selon l'une des revendications précédentes, caractérisé en ce que la couche (20) thermiquement isolante est réalisée par une couche de gaz.

22. Elément suivant l'une des revendications 1 à 21, caractérisé en ce que la couche thermiquement isolante est réalisée par un espace situé entre les deux vitres et au moins partiellement évacué.

23. Elément suivant l'une des revendications précédentes, caractérisé en ce que l'unité photovoltaique (18) consiste en une matière semi-conductrice poly- ou monocristalline.

24. Elément suivant l'une des revendications 1 à 22, caractérisé en ce que l'unité photovoltaique (18) consiste en une matière semi-conductrice amorphe.

25. Elément suivant l'une des revendications précédentes, caractérisé en ce que l'unité photovoltaique (18) n'occupe qu'une partie de l'étendue de l'élément.

26. Elément suivant la revendication 25, caractérisé en ce que l'unité photovoltaique (18) est réalisée en tant que bande horizontale.
